# EUROPÄISCHE PATENTANMELDUNG

(11) **EP 1 180 797 A2**
(43) Veröffentlichungstag der Anmeldung: **20.02.2002**
(21) Anmeldenummer: 01119073.3
(22) Anmeldetag: 07.08.2001
(51) Int. Cl.: H01L 21/8242

(54) **Verfahren zur Herstellung von Kondensatorelektroden**

(30) Priorität: 07.08.2000 DE 10038378
(71) Anmelder: Infineon Technologies AG, 81669 München (DE)
(72) Erfinder: Gschwandtner, Alexander, Dr., 80687 München (DE); Gutsche, Martin, 84405 Dorfen (DE)
(74) Vertreter: Ginzel, Christian

(57) **Zusammenfassung**

Mit Hilfe des erfindungsgemäßen Verfahrens kann die Rauhigkeit einer HSG-Oberfläche weitgehend auf die Oberfläche einer Elektrode übertragen werden. Die Elektrode erhält somit eine mikrostrukturierte Oberfläche, deren Flächeninhalt um mehr als 25%, bevorzugt um mehr als 50% und insbesondere bevorzugt um mehr als 100%, gesteigert werden kann. Dabei wird eine HSG-Schicht dazu verwendet, um die Elektrodenoberfläche bzw. die Opferschicht lokal zu maskieren. Nachfolgende Strukturierungsverfahren, wie beispielsweise nasschemische und/oder plasmagestützte Ätzverfahren, Nitridierungs- bzw. Oxidationsprozesse, erlauben es - basierend auf Mikromaskierungseffekten - die Elektrodenoberfläche beträchtlich aufzurauhen und somit die Elektrodenoberfläche zu vergrößern.

## Beschreibung

Die vorliegende Erfindung betrifft ein Verfahren zur Herstellung von Kondensatorelektroden. Die vorliegende Erfindung betrifft insbesondere ein Verfahren zur Herstellung von Kondensatorelektroden in Gräben, wie sie beispielsweise in hochintegrierten Speicherbausteinen eingesetzt werden.

Um die in einem Speicherkondensator einer Speicherzelle gespeicherte Ladung reproduzierbar auslesen zu können, sollte die Kapazität des Speicherkondensators mindestens einen Wert von etwa 30 fF besitzen. Gleichzeitig muß die laterale Ausdehnung des Kondensators ständig verkleinert werden, um eine Erhöhung der Speicherdichte erzielen zu können. Diese gegenläufigen Anforderungen an den Kondensator der Speicherzellen führen zu einer immer komplexeren Strukturierung des Kondensators ("Trench-Kondensatoren", "Stack-Kondensatoren", "Kronen-Kondensatoren"), um trotz kleiner werdender lateraler Ausdehnung des Kondensators eine ausreichende Kondensatorfläche bereitstellen zu können.

Um bei Stack-Kondensatoren bzw. Kronen-Kondensatoren auch bei einer kleiner werdenden laterale Ausdehnung des Speicherkondensators eine zumindest gleich bleibende Kapazität des Speicherkondensators garantieren zu können, werden häufig Kondensatorelektroden aus HSG-Silizium (Hemispherical Grain) eingesetzt. Die Verwendung von HSG-Silizium ist eine in der Halbleiterindustrie bekannte und erprobte Methode, die Oberfläche von Kondensatorelektroden zu vergrößern, um auf diese Weise die Gesamtkapazität des Kondensators zu erhöhen. Dabei werden mit Hilfe spezieller Abscheideverfahren und/oder spezieller Temperaturbehandlungen auf der Kondensatoroberfläche kleine, einige 10 - 100 nm große Siliziumkörner erzeugt. Aufgrund der Siliziumkörner erhalten die Kondensatorelektroden eine aufgerauhte und dadurch vergrößerte Oberfläche, was zu einer erhöhten Kapazität der Speicherkondensatoren führt.

Verfahren zur Erzeugung von HSG-Silizium (Hemispherical Grain) sind beispielsweise in den Dokumenten US 5,858,852 oder US 5,858,837 sowie US 5,723,379 beschrieben. Verfahren zur Erhöhung der Kapazität von Kondensatoren unter Verwendung von HSG-Silizium sind beispielsweise in den Dokumenten US 5,877,061 oder US 5,872,033 sowie US 5,972,771 beschrieben. Bei den Verfahren nach den Dokumenten US 5,872,033 sowie US 5,972,771 werden die HSG-Körner durch eine Ätzung nachbehandelt, so daß sich der Abstand zwischen den HSG-Körner vergrößert. Auf diese Weise läßt sich die Elektrodenoberfläche gezielt vergrößern. Leider bringen die genannten Verfahren auch eine Reihe von Nachteilen mit sich. Die Verwendung von HSG-Körnern als wesentlicher Bestandteil der Kondensatorelektroden führt zu einem erhöhtem Leckstrom in dem jeweiligen Kondensator. Weiterhin können die HSG-Körner an der Elektrodenoberfläche zu Kurzschlüssen zwischen benachbarten Kondensatoren führen.

Neben Stack-Kondensatoren bzw. Kronen-Kondensatoren werden auch sogenannte Trench-Kondensatoren eingesetzt, um bei einer kleiner werdenden laterale Ausdehnung des Speicherkondensators eine zumindest gleich bleibende Kapazität des Speicherkondensators garantieren zu können. Während bei Speicherzellen mit Stack-Kondensatoren bzw. Kronen-Kondensatoren der Speicherkondensator oberhalb der Auswahltransitoren angeordnet ist, ist bei Speicherzellen mit Trench-Kondensatoren der Speicherkondensators unterhalb der Auswahltransitoren im Halbleitersubstrat angeordnet.

Dabei führt die zunehmende Integrationsdichte der Speicherbausteine bei Speicherzellen mit Trench-Kondensatoren zu ständig abnehmenden Trenchdurchmessern. Um trotz abnehmender Trenchdurchmesser eine von Generation zu Generation in etwa gleich bleibende Kondensatorkapazität zu gewährleisten, konnte bisher die Trenchtiefe in gewissem Rahmen vergrößert werden. Dieser direkte Weg stößt jedoch an technologische sowie wirtschaftliche Grenzen. Zum einen benötigt man für eine Vertiefung des Trenches Ätzverfahren, welche die Realisierung immer höherer Aspektverhältnisse erlauben. Hier zeigen sich bereits prozessinherente Grenzen. Zum anderen limitiert selbst beim Vorhandensein solcher Ätzprozesse die verlängerte Ätzzeit ab einer bestimmten Atztiefe die Wirtschaftlichkeit des Vorgehens.

Eine Verwendung von HSG-Silzium in Trench-Kondensatoren, um ähnlich wie bei Stack-Kondensatoren bzw. Kronen-Kondensatoren die Elektrodenoberfläche zu vergrößern, ist eine Option zur Vergrößerung der Elektrodenoberfläche. Das Aufwachsen von HSG-Silizium auf den Seitenwänden der Gräben reduziert jedoch spürbar den Grabendurchmesser. Dadurch kann es beim späteren Erzeugen der dielektrischen Schicht sowie dem späteren Füllen der Gräben mit den Gegenelektroden zu beträchtlichen Problemen kommen. Das HSG-Silizium kann beispielsweise innerhalb der Gräben zu Engstellen führen, die ein weiteres Füllen des Grabens verhindern ("Abschnüreffekt").

Der vorliegenden Erfindung liegt daher die Aufgabe zugrunde, ein Verfahren zur Herstellung von Kondensatorelektroden anzugeben, das die Nachteile der herkömmlichen Verfahren vermindert bzw. ganz vermeidet. Insbesondere ist es die Aufgabe der vorliegenden Erfindung, ein Verfahren zur Herstellung von Kondensatorelektroden in Gräben anzugeben, das es ermöglicht, Trench-Kondensatoren mit einer ausreichenden Kapazität herzustellen, ohne die Tiefe der Gräben zu vergrößern.

Diese Aufgabe wird von dem Verfahren zur Herstellung von Kondensatorelektroden gemäß dem unabhängigen Patentanspruch 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung von Kondensatorelektroden mit den folgenden Schritten bereitgestellt:
a) eine Elektrode wird bereitgestellt,
b) auf die Elektrode wird zumindest eine Opferschicht aufgebracht;
c) auf die Opferschicht wird eine diskontinuierliche Schicht aufbracht,
d) die Elektrode wird mit Hilfe der diskontinuierliche Schicht und der Opferschicht strukturiert, so daß eine Elektrode mit einer vergrößerten Oberfläche erzeugt wird.

Mit Hilfe des erfindungsgemäßen Verfahrens kann die Rauhigkeit der Oberfläche der diskontinuierliche Schicht weitgehend auf die Oberfläche der Elektrode übertragen werden. Die Elektrode erhält somit eine mikrostrukturierte Oberfläche, deren Flächeninhalt um mehr als 25%, bevorzugt um mehr als 50% und insbesondere bevorzugt um mehr als 100%, gesteigert werden kann. Dabei wird die diskontinuierliche Schicht dazu verwendet, die Elektrodenoberfläche bzw. die Opferschicht lokal zu maskieren. Nachfolgende Strukturierungsverfahren, wie beispielsweise nasschemische und/oder plasmagestützte Ätzverfahren, Nitridierungs- bzw. Oxidationsprozesse, erlauben es - basierend auf Mikromaskierungseffekten - die Elektrodenoberfläche beträchtlich aufzurauhen und somit die Elektrodenoberfläche zu vergrößern.

Leider läßt sich nicht jede diskontinuierliche Schicht ohne Schwierigkeiten auf jede beliebige Elektrodenoberflächen aufbringen. Beispielsweise ist es schwierig, HSG-Silizium, das bevozugt als diskontinuierlche Schicht verwendet wird, mit einer ausreichenden Rauhigkeit auf monokristallines Silizium aufzubringen. Durch die Verwendung einer Opferschicht kann jedoch eine Oberfläche bereitgestellt werden, auf die sich die diskontinuierliche Schicht gut aufbringen läßt. Dementsprechend ergibt sich eine größere Auswahl an Materialien, die als Elektrodenmaterial eingesetzt werden können. Weiterhin gewährleistet die Opferschicht bei der eingentlichen Mikrostrukturierung der Elektrodenoberfläche eine ausreichende Selektivität gegenüber der Elektrodenoberfläche.

Das erfindungsgemäße Verfahren besitzt darüber hinaus den Vorteil, daß die diskontinuierliche Schicht entweder bei der Strukturierung der Elektrode automatisch entfernt wird oder durch einen zusätzlichen Prozeßschritt nach der Strukturierung der Elektroden wieder entfernt werden kann. Man erhält somit im wesentlichen die geometrische Oberflächenstruktur der diskontinuierliche Schicht ohne für die diskontinuierliche Schicht selbst Raum bereit halten zu müssen. Dies ist insbesondere für die Erzeugung von Elektroden in Trench-Kondensatoren wichtig, da die diskontinuierliche Schicht dort zu einer Verengung des Kondensatorgrabens führen würde. Weiterhin besitzt das erfindungsgemäße Verfahren den Vorteil, daß das Elektrodenmaterial nicht mehr auf das Material der diskontinuierliche Schicht, beispielsweise HSG-Silizium, eingeschränkt ist. So kann nun auch einkristallines Silizium für einen sogenannten "Rauh-Silizium-Kondensator" verwendet werden, wodurch sich die Leckstromeigenschaften des Kondensators deutlich verbessern.

Gemäß einer bevorzugten Ausführungsform wird die diskontinuierliche Schicht so abgeschieden, daß benachbarte Körner bzw. Inseln verschmelzen und somit größere zusammenhängende Bereiche entstehen, zwischen denen kleinere unbedeckte Öffnungen verbleiben. Als Alternative dazu kann die diskontinuierliche Schicht so abgeschieden werden, daß benachbarte Körner bzw. Inseln im wesentlichen voneinander getrennt angeordnet sind. Welche dieser Alternativen verwendet wird, hängt im wesentlichen davon ab, ob die Struktur der diskontinuierlichen Schicht im positiven bzw. negativen Sinne in die Elektrode übertragen werden soll. Weiterhin ist es bevorzugt, wenn als diskontinuierliche Schicht eine HSG-Schicht, insbesondere HSG-Silizium oder HSG-SiGe (Silizium/Germanium), verwendet wird.

Gemäß einer bevorzugten Ausführungsform wird die Opferschicht zu einer Maske strukturiert, welche zur Strukturierung der Elektrode verwendet wird. Dabei ist es insbesondere bevorzugt, wenn die Opferschicht selektiv zur Elektrode und/oder selektiv zur diskontinuierlichen Schicht strukturiert wird. Bevorzugt wird zur Strukturierung der Opfeerschicht naßchemisches oder ein trockenchemisches Verfahren eingesetzt.

Gemäß einer weiteren bevorzugten Ausführungsform wird als Opferschicht eine Oxidschicht oder Nitridschicht bzw. Oxid/Nitrid-Doppelschicht verwendet.

Weiterhin ist es bevorzugt, wenn die diskontinuierliche Schicht nitridiert wird. Ebenso ist es bevorzugt, wenn als Opferschicht eine Nitridschicht verwendet und vor der Strukturierung der Opferschicht die diskontinuierliche Schicht zumindest teilweise oxidiert wird.

Weiterhin ist es bevorzugt, wenn die Elektrode durch eine isotrope Ätzung oder durch eine Oxidation mit anschließender isotroper Ätzung strukturiert wird. Dabei ist es insbesondere bevorzugt, wenn mit Hilfe einer Nitridmaske in der Elektrode Oxidbereiche erzeugt werden, welche später als Ätzmaske für eine isotrope Ätzung der Elektrode dienen.

Gemäß einer weiteren bevorzugten Ausführungsform wird als Opferschicht eine Oxidschicht verwendet und eine Nitridierung durchgeführt, so daß in der Elektrode Nitridbereiche erzeugt werden. Dabei ist es insbesondere bevorzugt, wenn die Elektrode mit den Nitridbereichen nachfolgend oxidiert und durch eine isotrope Oxidätzung strukturiert wird. Weiterhin ist es bevorzugt, wenn die Nitridbereiche in der Elektrodenoberfläche als Maske für eine isotrope Ätzung verwendet werden.

Gemäß einer weiteren bevorzugten Ausführungsform wird als Material für die Elektrode monokristallines oder polykristallines Silizium verwendet.

Die Erfindung wird nachfolgend anhand von Figuren der Zeichnung näher dargestellt. Es zeigen:
- Fig. 1 - 7: ein Verfahren zur Herstellung von Kondensatorelektroden gemäß einer ersten Ausführungsform der vorliegenden Erfindung,
- Fig. 8 - 11: ein Verfahren zur Herstellung von Kondensatorelektroden gemäß einer weiteren Ausführungsform der vorliegenden Erfindung.
- Fig. 12 - 15: ein Verfahren zur Herstellung von Kondensatorelektroden gemäß einer weiteren Ausführungsform der vorliegenden Erfindung.
- Fig. 16 - 19: ein Verfahren zur Herstellung von Kondensatorelektroden gemäß einer weiteren Ausführungsform der vorliegenden Erfindung.

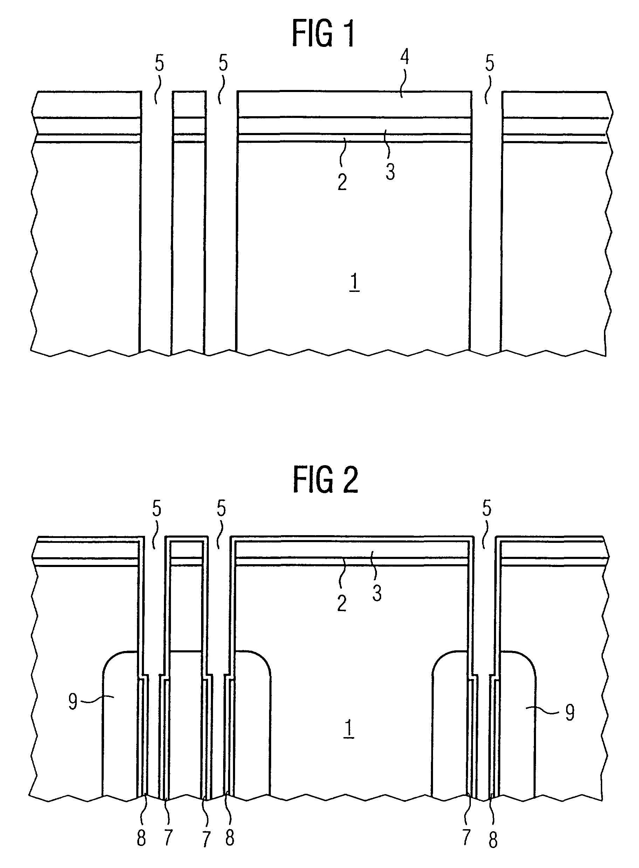

Die Figuren 1 bis 5 zeigen eine erste Ausführungsform der vorliegenden Erfindung. Auf einem Siliziumsubstrat 1 ist eine Siliziumoxidschicht 2, eine Siliziumnitridschicht 3 und eine weitere Siliziumoxidschicht 4 angeordnet. Die Siliziumoxidschichten 2 und 4 sowie die Siliziumnitridschicht 3 werden mit Hilfe einer Phototechnik strukturiert, so daß diese Schichten anschließend als eine Maske für die Ätzung der Gräben dienen können. Im vorliegenden Beispiel ist das Siliziumsubstrat 1 schwach p-dotiert. Es folgt die Ätzung der Gräben 5. Durch die Ätzung entstehen etwa 1 - 10 µm tiefe Gräben 5. Die sich daraus ergebende Situation ist in Fig. 1 gezeigt.

Anschließend wird die Siliziumoxidschicht 4 entfernt. Es folgt die Abscheidung einer Schicht aus Arsenglas 7. Durch eine weitere Phototechnik werden die Gräben 5 bis zu einer vorgegebenen Höhe mit Photolack (nicht gezeigt) gefüllt und durch eine Ätzung der Arsenglasschicht 7 wird die Arsenglasschicht 7 oberhalb des Photolacks wieder entfernt. Nach Entfernung des Photolacks wird die Schicht aus Arsenglas 7 mit einer weiteren Siliziumoxidschicht 8 bedeckt. Diese zusätzliche Siliziumoxidschicht 8 verhindert eine Verunreinigung der Umgebung durch das ausdiffundierende Arsen.

Nachfolgend wird eine Wärmebehandlung durchgeführt, um den Dotierstoff Arsen aus der in den Gräben 5 verbliebenen Arsenglasschicht 7 in das Substrat 1 einzubringen. Dadurch entsteht in den Seitenwänden der Gräben 5 jeweils ein n-leitendes Diffusionsgebiet, das jeweils eine erste Elektrode 9 bildet. Damit ist der erste Schritt des erfindungsgemäßen Verfahrens nämlich die Bereitsteillung einer Elektrode abgeschlossen. Die sich daraus ergebende Situation ist Fig. 2 dargestellt.

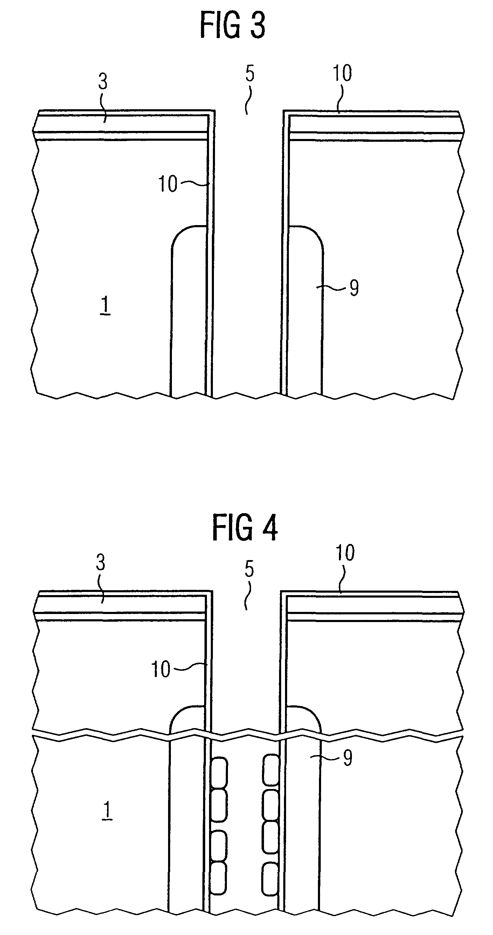

Anschließend werden die Schichten 7 und 8 sowie das natürlichen Oxid, das sich in der Regel auf der kristallinen Siliziumoberfläche ausbildet, z.B. durch eine nasschemische HF Ätzung oder HF Dampf entfernt. Danach wird eine Opferschicht, beispielsweise eine Siliziumnitridschicht 10, auf der Elektrodenoberfläche erzeugt. Das Aufbringen der Siliziumnitridschicht 10 erfolgt bevorzugt durch thermische Nitridation (RTN oder Ofen) der kristallinen Siliziumoberfläche und/oder durch Abscheidung einer dünnen Siliziumnitridschicht mit Hilfe eines CVD-Verfahrens. Damit ist der zweite Schritt des erfindungsgemäßen Verfahrens nämlich die Aufbringung einer Opferschicht abgeschlossen. Die sich daraus ergebende Situation ist Fig. 3 dargestellt.

Nachfolgend wird eine diskontinuierliche Schicht abgeschieden. Dies bedeutet" daß eine Schicht abgeschieden wird, welche die Opferschicht nicht vollständig bedeckt sondern zwischen einzelen Körnern oder Inseln bzw. zwischen größeren zusammenhängenden Bereichen von Körnern oder Inseln immer wieder unbedeckte Öffnungen zu der Opferschicht aufweist.

Im vorliegenden Beispiel ist die diskontinuierliche Schicht eine HSG-Schicht, insbesondere HSG-Silizium, die auf die Opferschicht aufgebracht wird. Dafür stehen eine Reihe von Verfahren zur Verfügung. So kann beispielsweise Silizium bei der Übergangstemperatur Tc (etwa 550° - 580°C) zwischen amorphem und polykristallinem Silizium abgeschieden werden. Dabei bildet sich in-situ das körnige HSG-Silizium. Alternativ dazu kann amorphes (nicht aufgerauhtes) Silizium bei einer Temperatur deutlich unterhalb der Übergangstemperatur Tc abgeschieden werden. Der Abscheidung des amorphen Siliziums folgt ein Temperschritt bei oder oberhalb der Übergangstemperatur Tc. Bei diesem Verfahren wird das zunächst glatte amorphe Silizium erst im nachfolgenden Temperschritt in das rauhe bzw. körnige HSG-Silizium umgewandelt.

Ein weiteres Verfahren zur Herstellung von HSG-Silizium ergibt sich durch die Abscheidung von amorphem Silizium gefolgt von einer Bekeimung der amorphen Schicht bei der Übergangstemperatur Tc zur Erzeugung von Siliziumkristalliten. Anschließend wird eine Nachtemperung der bekeimten Siliziumschicht durchgeführt, um ausgewachsene HSG-Körner zu erzeugen. Während der Nachtemperung wachsen die Körner, indem sie aus der noch unverbrauchten amorphen Siliziumschicht Material inkorporieren. Je nach Prozeßführung kann dabei auf eine Nachtemperung auch verzichtet werden.

Bevorzugt soll HSG-Silizium selektiv nur an bestimmten Stellen entstehen. Dementsprechend kann nach Abscheidung des amorphen Siliziums eine Strukturierung der amorphen Siliziumschicht durchgeführt werden. Dies kann beispielsweise durch nasschemische oder trockenchemische Verfahren erfolgen. Anschließend folgt eine selektive Bekeimung der amorphen Siliziumschicht bei der Übergangstemperatur Tc zur Erzeugung von Siliziumkristalliten. Die Prozessparameter werden dabei so gewählt, dass sich das Silizium nur auf einer Siliziumunterlage abscheidet, nicht aber z.B. auf Siliziumoxid und/oder Siliziumnitrid. Wird eine selektive HSG-Abscheidung verwendet, so kann der obere Bereich der Gräben 5, der später den sogenannten Collar aufnimmt, vor den Auswirkungen der Mikrostrukturierung der Elektrodenoberfläche zuverlässig geschützt werden.

Als ein weiteres Verfahren zur Erzeugung von HSG-Silizium kann auch eine direkte Nukleation von polykristallinem Silizium eingesetzt werden, die in einem weiten Temperaturbereich oberhalb Tc möglich ist. Dabei kommt es in der Regel zu einem Inselwachstum auf amorpher Unterlage.

Allen Methoden zur Bildung von HSG-Körnern 11 ist gemein, daß zunächst Si-Kristallite gebildet werden, die anschliessend an Größe zunehmen und unter geeigneten Prozessbedingungen keine vollständig zusammenhängende Schicht bilden, sondern zur Entstehung von Siliziumkörnern führen. Dementsprechend bildet sich stark oberflächenvergrößertes HSG-Silizium. Bevorzugt wird das HSG-Silizium so abgeschieden, daß benachbarte Körner 11 verschmelzen und somit größere zusammenhängende Bereiche entstehen, zwischen denen kleinere unbedeckte Öffnungen verbleiben. Die sich daraus ergebende Situation ist Fig. 4 dargestellt.

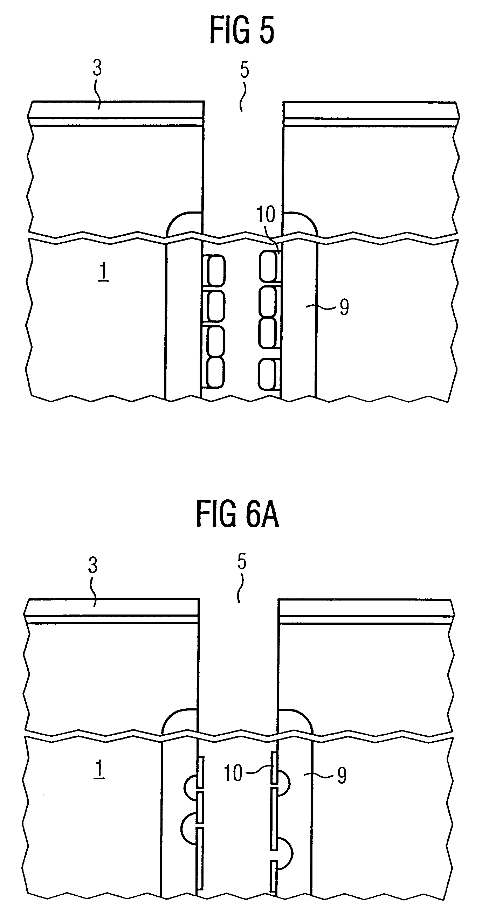

Es folgt die Strukturierung der Opferschicht 10 unter Ausnutzung der Mikromaskierungseffekte des HSG-Siliziums. So wird aus der Siliziumnitridschicht 10 beispielsweise durch eine nasschemische oder trockenchemische Ätzung eine Maske erzeugt, welche nachfolgend zur eigentlichen Strukturierung der Elektrode 9 verwendet wird. Die sich daraus ergebende Situation ist Fig. 5 dargestellt.

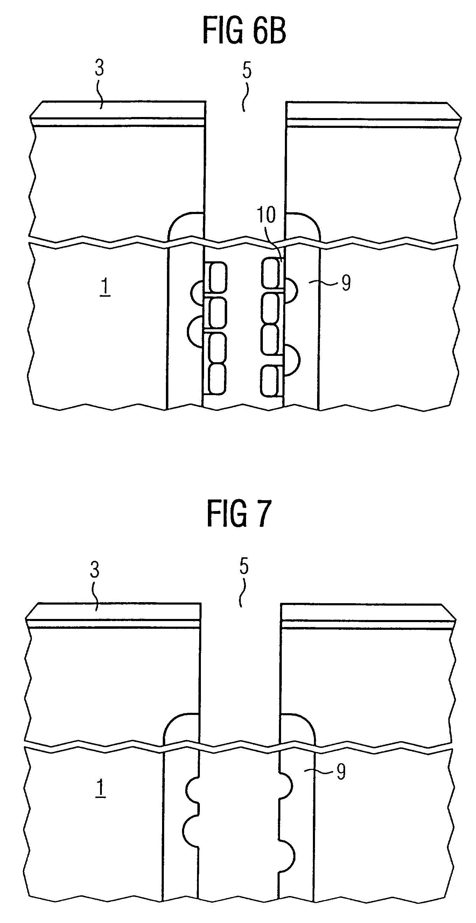

Es folgt der Transfer der Oberflächenrauhigkeit in das kristalline Silizium, d.h. die Strukturierung der Elektrode 9. Die Strukturierung erfolgt dabei bevorzugt durch ein isotropes Zurückätzen (nasschemisch oder mittels Trockenätzen, z.B. CDE) oder durch ein Aufoxidieren in das kristalline Silizium hinein mit anschließender Entfernung des Oxids. Fig. 6A zeigt das Ergebnis eines isotropen Äzschritts während Fig. 6B das Ergebnis einer Aufoxidation darstellt.

Anschließend wird die Siliziumnitridmaske bzw. die Siliziumnitridmaske und das aufoxidierte Silizium entfernt, so daß nur die mikrostrukturierte Elektrode 9 zurückbleibt (Fig. 7). Auf Grund der Mikrostrukturierung besitzt die Elektrode nun eine deutlich vergrößerte Oberfläche, was sich dementsprechend in einer erhöhten Kapazität des noch zu erzeugenden Kondensators wiederspiegelt. Es folgen nun die Erzeugung der dielektrischen Schicht des Kondensators sowie die Erzeugung der zweiten Kondensatorelektrode. Anschließend wird im oberen Bereich des Grabens ein sogenannter Collar und der Kontakt zu dem noch zu erzeugenden Auswahltransistor erzeugt. Die dafür notwendigen Schritte sind bekannt und werden daher nicht näher erläutert.

Ausgehend von Fig. 4 kann zusätzlich eine thermische Oxidation (RTO) der Oberfläche durchgeführt werden, um etwaige Siliziumreste zwischen den HSG-Körner 11 aufzuoxidieren. Diese werden dann beispielsweise mit Hilfe einer nasschemischen HF-Behandlung entfernt. Bevorzugt schließt sich nochmals eine thermische Oxidation des HSG-Siliziums an, um eine Oxidmaske zu erzeugen, welche die anschließende Strukturierung der Nitridmaske erleichtert. Dabei können die Parameter dieser Oxidation so gewählt, daß nur ein kleiner Teil an der Oberfläche der HSG-Körner 11 oxidiert wird. Die Parameter der Oxidation können aber auch so gewählt werden, daß die HSG-Körner 11 vollständig oxidieren.

In einer weiteren Alternative kann anstatt einer Oxidation der HSG-Körner 11 eine Nitridierung der HSG-Körner 11 bzw. eine Abscheidung einer dünnen Siliziunitridschicht durchgeführt werden. Im Fall der Nitridierung entsteht im Bereich der HSG-Körner ein SiN/Si/SiN-Schichtstapel, der in geeigneter Ätzchemie deutlich resistenter ist als die einfache SiN-Schicht zwischen den Körnern. Während der Nitridierung wird im wesentlichen nur das Silizium der HSG-Körner oberflächlich in Siliziumnitrid umgewandelt während die SiN-Schicht zwischen den HSG-Körnern aufgrund des Sättigungsverhaltens praktisch nicht an Dicke zunimmt.

Nach der Strukturierung bzw. Ausbildung der Nitridmaske folgt wiederum der Transfer der Oberflächenrauhigkeit in das kristalline Silizium, wie er bereits in Zusammenhang mit den Figuren 6A bzw. 6B beschrieben wurde.

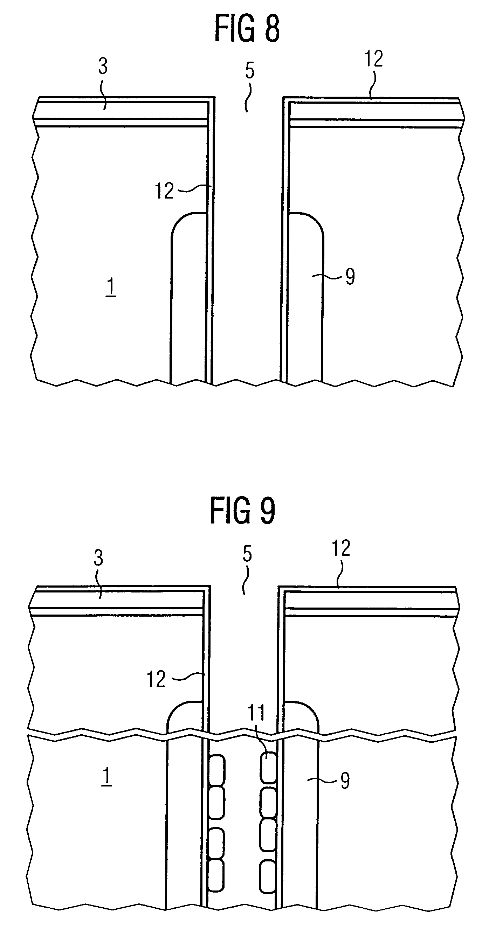

Die Figuren 8 bis 11 zeigen eine weitere Ausführungsform der vorliegenden Erfindung. Die ersten Schritte dieses Verfahren entsprechen dabei den Schritten, wie sie in Zusammenhang mit den Figuren 1 bis 2 erläutert wurden, so daß eine Wiederholung der Beschreibung dieser Schritte verzichtet werden kann.

Ausgehend von Fig. 2 werden wiederum die Schichten 7 und 8 sowie bevorzugt das natürlichen Oxid, das sich in der Regel auf der kristallinen Siliziumoberfläche ausbildet, z.B. durch eine nasschemische HF Ätzung oder HF Dampf entfernt. Danach wird eine Opferschicht, in dieser Ausführungsform eine Siliziumoxidschicht 12, auf der Elektrodenoberfläche erzeugt. Das Aufbringen der Siliziumoxidschicht 12 erfolgt bevorzugt durch thermische Oxidation (RTO oder Ofen) der kristallinen Siliziumoberfläche und/oder durch Abscheidung einer dünnen Siliziumoxidschicht mit Hilfe eines CVD-Verfahrens. Damit ist der zweite Schritt des erfindungsgemäßen Verfahrens, nämlich die Aufbringung einer Opferschicht, abgeschlossen. Die sich daraus ergebende Situation ist in Fig. 8 dargestellt.

Nachfolgend wird eine HSG-Schicht, insbesondere HSG-Silizium, auf die Opferschicht aufgebracht. Wiederum wird das HSG-Silizium bevorzugt so abgeschieden, daß benachbarte Körner 11 verschmelzen und somit größere zusammenhängende Bereiche entstehen, zwischen denen kleinere unbedeckte Öffnungen verbleiben. Die sich daraus ergebende Situation ist Fig. 9 dargestellt.

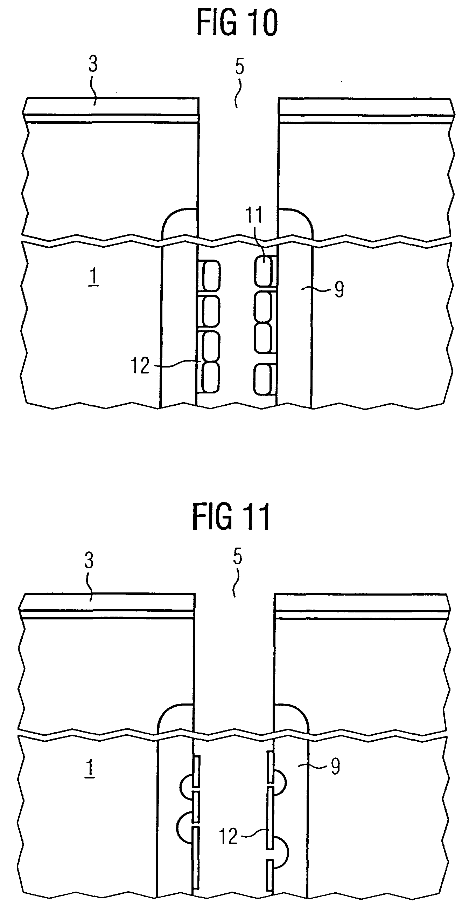

Bevorzugt wird nun eine thermische Oxidation (RTO) der Oberfläche durchgeführt, um etwaige Siliziumreste zwischen den HSG-Körner aufzuoxidieren. Diese werden dann zusammen mit den freiliegenden Bereichen der Opferschicht beispielsweise mit Hilfe einer nasschemischen HF-Behandlung entfernt (Fig. 10).

Es folgt der Transfer der Oberflächenrauhigkeit in das kristalline Silizium, d.h. die Strukturierung der Elektrode 9. Die Strukturierung erfolgt dabei bevorzugt durch ein isotropes Zurückätzen (Fig. 11) oder durch ein Aufoxidieren in das kristalline Silizium hinein mit anschließender Entfernung des Oxids. Anschließend werden Oxidreste nochmals durch eine HF-Ätzlösung entfernt.

In einer alternative Ausführungsform kann auch nach dem Aufbringen des HSG-Siliziums direkt ein Aufoxidieren in das kristalline Silizium hinein erfolgen. Auf eine vorherige Strukturierung der Opferschicht wird dabei verzichtet. Anschließend wird das Oxid von der Oberfläche entfernt, so daß eine mikrostrukturierte Elektrodeoberfläche zurückbleibt.

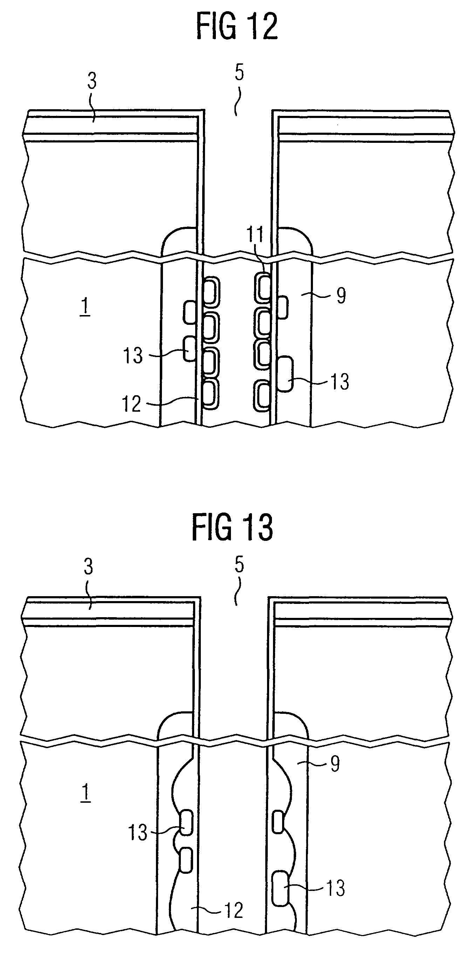

Die Figuren 12 bis 15 zeigen eine weitere Ausführungsform der vorliegenden Erfindung. Die ersten Schritte dieses Verfahren entsprechen dabei den Schritten, wie sie in Zusammenhang mit den Figuren 1 und 2 sowie den Figuren 8 und 9 erläutert wurden.

Ausgehend von Fig. 9 wird mit Hilfe eines RTN-Schrittes die Grenzflaeche zum kristallinen Silizium unter der Opferschicht aufnitridiert. Zwischen den HSG-Körnern entsteht somit die Schichtfolge: monokristallines Silizium 1, Siliziumnitrid 13, Siliziumoxid 12. Die sich daraus ergebende Situation ist in Fig. 12 dargestellt. Nachfolgend werden die HSG-Körner sowie das sie bedeckende Siliziumnitrid selektiv zu dem Siliziumoxid der Opferschicht entfernt.

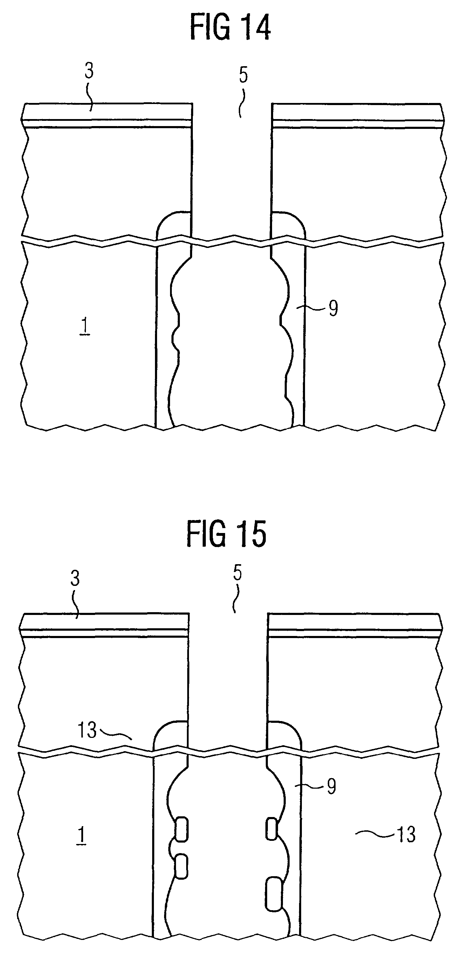

Es folgt der Transfer der Oberflächenrauhigkeit in das kristalline Silizium, d.h. die Strukturierung der Elektrode 9. Die Strukturierung erfolgt dabei bevorzugt durch ein Aufoxidieren in das kristalline Silizium hinein mit anschließender Entfernung des Oxids. Fig. 13 zeigt das Ergebnis der Oxidation während Fig. 14 die Situation nach der Entfernung des Oxids bzw. des Nitrids darstellt.

Als Alternative zu einer Oxidation kann die Opferschicht auch selektiv zu dem Silzium und dem Siliziumnitrid entfernt werden. Anschließend wird eine isotrope Ätzung durchgeführt, wobei die Siliziumnitridinseln als Ätzmaske dienen. Die sich daraus ergebende Situation ist Fig. 15 dargestellt. Nach der Entfernung der Siliziumnitridmaske erhält man wiederum eine mikrostrukturierte Elektrodenoberfläche, deren Flächeninhalt durch die Mikrostrukturierung deutlich erhöht wurde.

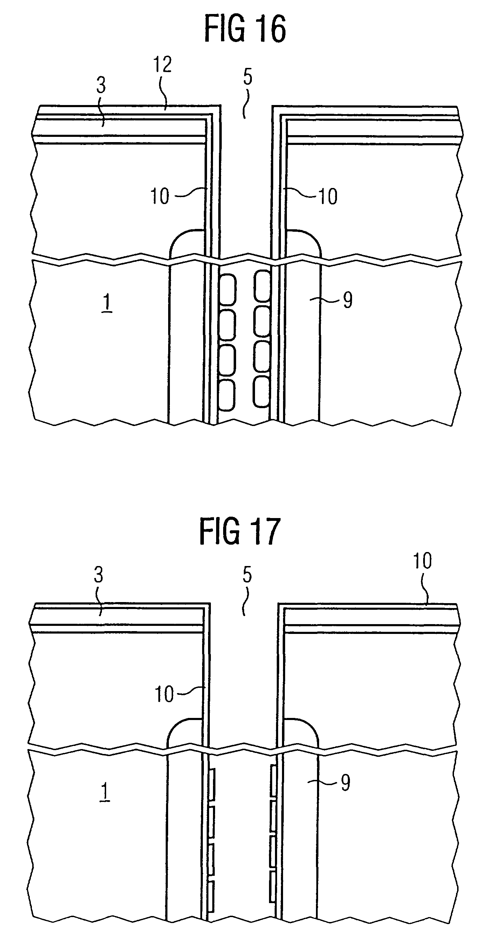

Die Figuren 16 bis 19 zeigen eine weitere Ausführungsform der vorliegenden Erfindung. Die ersten Schritte dieses Verfahren entsprechen dabei den Schritten, wie sie in Zusammenhang mit den Figuren 1 und 2 erläutert wurden.

Nachfolgend wird eine untere Siliziumnitridschicht auf dem kristallinen Silizium, z.B. durch thermische Nitridation und/oder durch Abscheidung einer dünnen Siliziumnitridschicht 10 etwa mit Hilfe eines CVD Verfahrens, ausgebildet. Anschließend eine obere Siliziumoxidschicht 12 z.B. mit Hilfe eines CVD-Verfahrens erzeugt. Diese Doppelschicht aus Siliziumnitrid- und Siliziumoxidschicht übernimmt bei dieser Ausführungsform der Erfindung die Rolle der Opferschicht.

Anschließend wird eine HSG-Schicht, insbesondere HSG-Silizium, auf die Opferschicht aufgebracht. Das HSG-Silizium wird dabei bevozugt so abgeschieden, daß benachbarte Körner 11 voneinander getrennt angeordnet sind und nicht zu größeren Clustern verschmelzen. Die sich daraus ergebende Situation ist Fig. 16 dargestellt.

Um etwaige Siliziumreste zwischen den HSG-Körner 11 zu entfernen, kann kurz aufoxidiert und das sich bildende Oxid durch eine Ätzung entfernt werden. Anschließend wird eine Siliziumoxidätzung, beispielsweise mit der Hilfe von HF, selektiv zu der Siliziumnitridschicht durchgeführt, wobei die HSG-Körner als Ätzmaske dienen. Weiterhin werden die HSG-Körner selektiv zu der Unterlage entfernt. Die sich daraus ergebende Situation ist Fig. 17 dargestellt.

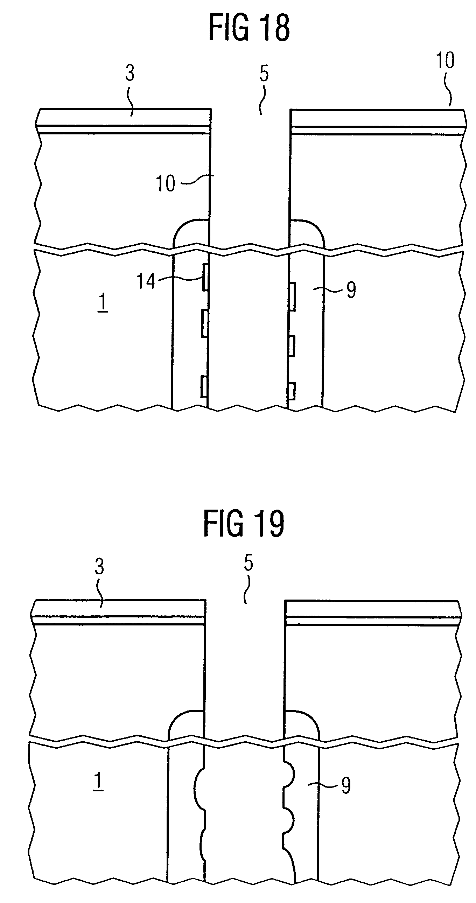

Es folgt die Strukturierung der Siliziumnitridschicht, wobei die Oxidinseln Ätzmaske dienen. Nach der Strukturierung der Siliziumnitridschicht werden die Oxidinseln entfernt, so daß nur eine Siliziumnitridmaske auf der Elektrode verbleibt. Anschließend erfolgt eine Oxidation 14 des freigelegten kristallinen Siliziums der Elektrode 9 sowie eine Entfernung der Siliziumnitridmaske. Die sich daraus ergebende Situation ist Fig. 18 dargestellt.

Durch eine isotrope Ätzung des Silizium wird die Elektrode 9 weiter strukturiert. Dabei dient das Siliziumoxid als Ätzmaske. Anschließend wird das Siliziumoxid 14 selektiv zu dem kristallinen Silizium entfernt, so daß wiederum eine mikrostrukturierte Elektrodenoberfläche erzeugt wurde, deren Flächeninhalt durch die Mikrostrukturierung deutlich erhöht ist. Die sich daraus ergebende Situation ist Fig. 19 dargestellt.

## Patentansprüche

1. Verfahren zur Herstellung von Kondensatorelektroden, mit den folgenden Schritten:
a) eine Elektrode wird bereitgestellt,
b) auf die Elektrode wird zumindest eine Opferschicht aufgebracht;
c) auf die Opferschicht wird eine diskontinuierliche Schicht aufbracht,
d) die Elektrode wird mit Hilfe der diskontinuierlichen Schicht und der Opferschicht strukturiert, so daß eine Elektrode mit einer vergrößerten Oberfläche erzeugt wird.

2. Verfahren nach Anspruch 1,
**dadurch gekennzeichnet, daß**
die diskontinuierliche Schicht so abgeschieden wird, daß benachbarte Körner verschmelzen und somit größere zusammenhängende Bereiche entstehen, zwischen denen kleinere unbedeckte Öffnungen verbleiben.

3. Verfahren nach Anspruch 1,
**dadurch gekennzeichnet, daß**
die diskontinuierliche Schicht so abgeschieden wird, daß benachbarte Körner im wesentlichen voneinander getrennt angeordnet sind.

4. Verfahren nach einem der vorherstehenden Ansprüche,
**dadurch gekennzeichnet, daß**
als diskontinuierliche Schicht eine HSG-Schicht, insbesondere HSG-Silizium oder HSG-SiGe, verwendet wird.

5. Verfahren nach einem der vorherstehenden Ansprüche,
**dadurch gekennzeichnet, daß**
die Opferschicht zu einer Maske strukturiert wird, welche zur Strukturierung der Elektrode verwendet wird.

6. Verfahren nach nach Anspruch 5,
**dadurch gekennzeichnet, daß**
die Opferschicht selektiv zur Elektrode und/oder selektiv zur diskontinuierlichen Schicht strukturiert wird.

7. Verfahren nach einem der vorherstehenden Ansprüche,
**dadurch gekennzeichnet, daß**
als Opferschicht eine Oxidschicht und/oder Nitridschicht verwendet wird.

8. Verfahren nach einem der vorherstehenden Ansprüche,
**dadurch gekennzeichnet, daß**
als Opferschicht eine Doppelschicht aus Siliziumoxid und Siliziumnitrid verwendet wird.

9. Verfahren nach einem der vorherstehenden Ansprüche,
**dadurch gekennzeichnet, daß**
die diskontinuierliche Schicht nitridiert wird.

10. Verfahren nach einem der vorherstehenden Ansprüche,
**dadurch gekennzeichnet, daß**
als Opferschicht eine Nitridschicht verwendet und vor der Strukturierung der Opferschicht die diskontinuierliche Schicht zumindest teilweise oxidiert wird.

11. Verfahren nach einem der vorherstehenden Ansprüche,
**dadurch gekennzeichnet, daß**
die Elektrode durch eine isotrope Ätzung oder durch eine Oxidation mit anschließender isotroper Ätzung strukturiert wird.

12. Verfahren nach einem der vorherstehenden Ansprüche,
**dadurch gekennzeichnet, daß**
mit Hilfe einer Nitridmaske in der Elektrode Oxidbereiche erzeugt werden, welche später als Ätzmaske für eine isotrope Ätzung der Elektrode dienen.

13. Verfahren nach einem der Ansprüche 1 bis 4,
**dadurch gekennzeichnet, daß**
als Opferschicht eine Oxidschicht verwendet und eine Nitridierung durchgeführt wird, so daß in der Elektrode Nitridbereiche erzeugt werden.

14. Verfahren nach Anspruch 13,
**dadurch gekennzeichnet, daß**
die Elektrode mit den Nitridbereichen oxidiert und durch eine isotrope Oxidätzung strukturiert wird.

15. Verfahren nach Anspruch 13,
**dadurch gekennzeichnet, daß**
die Nitridbereiche in der Elektrodenoberfläche als Maske für eine isotrope Ätzung verwendet werden.

16. Verfahren nach einem der vorherstehenden Ansprüche,
**dadurch gekennzeichnet, daß**
als Material für die Elektrode monokristallines oder polykristallines Silizium verwendet wird.
